# EUROPEAN PATENT APPLICATION

(11) **EP 2 833 428 A1**
(43) Date of publication of application: **04.02.2015**
(21) Application number: 12873428.2
(22) Date of filing: 31.03.2012
(51) Int. Cl.: H01L 51/50

(54) **ORGANIC ELECTROLUMINESCENCE DEVICE AND METHOD FOR MANUFACTURE THEREOF**

(71) Applicant: Ocean's King Lighting Science & Technology Co., Ltd, Shenzhen, Guangdong 518000 (CN); Shenzhen Ocean's King Lighting Engineering Co. Ltd., Guangdong 518100 (CN)
(72) Inventor: ZHOU, Mingjie, Shenzhen Guangdong 518000 (CN); WANG, Ping, Shenzhen Guangdong 518000 (CN); FENG, Xiaoming, Shenzhen Guangdong 518000 (CN); CHEN, Jixing, Shenzhen Guangdong 518000 (CN)
(74) Representative: Lenthall, Joseph
(86) International application number: PCT/CN2012/073418
(87) International publication number: WO 2013/143146

(57) **Abstract**

An organic electroluminescence device (100, 200) comprises a substrate (110), an anode (130), a light emitting layer (160) and a cathode (190) stacked sequentially. The anode (130) comprises a light transmittance increased layer (131), a conductive layer (132) and a hole injection auxiliary layer (133) stacked on the substrate (110) sequentially. The materials of the light transmittance increased layer (131) are inorganic compounds of zinc with a light transmittance of 400 nm to 800 nm in the visible region and a refractive index greater than 2.3. The material of the conductive layer (132) is graphene. The utilization of light transmittance increased principle for multilayer anode structure can make the light transmittance of the anode in the visible region high and surface resistance low. The utilization of inorganic material with hole injection ability can reduce the hole injection barrier, make the luminous performance of the organic electroluminescence device (100, 200) stable and luminous efficiency high. A method for manufacturing the organic electroluminescence device (100, 200) is also provided. The anode is prepared by vacuum evaporation and pulling method, which is convenient to operate and is suitable for large scale production.

## Description

### FIELD OF THE INVENTION

The present invention relates to an organic electroluminescent device and manufacturing method thereof.

### BACKGROUND OF THE INVENTION

Organic light emitting diode, hereinafter referred to as OLED, a promising display technique and light source, has characteristics such as high luminance, wide selection of material, low driving voltage and solid-state self-luminosity, as well as advantages such as high definition, wide viewing angle and fast response. OLED not only conforms to the development trends of mobile communication and information display in the information age, but also meets the requirements of green lighting technology, and has drawn considerable attention of many researchers at home and abroad.

Organic light emitting diode has a similar sandwich structure, comprising cathode and anode positioned separately on the top and the bottom, and one or more functional layers of organic materials sandwiched between the electrodes. The functional layers of organic materials have different materials and different structures. Organic electroluminescent device is carrier injection-type light emitting device. In the case where working voltage is supplied to anode and cathode, holes and electrons will inject into organic material layer of the device from the anode and cathode respectively, and form hole-electron pairs, then light comes out from one side of the electrodes.

Polymer film is usually used as substrate of organic electroluminescent device. Anode is prepared on the surface of substrate. However, such conductive film has many insurmountable problems in application for flexible OLED. For example, in the process of preparing ITO film, the doping proportion of various elements, such as indium and stannum, is difficult to control, resulting in uncontrollable morphology of ITO, carrier and transmission performance. Secondly, if conductive film such as ITO is prepared on flexible substrate, low-temperature sputtering technique is usually adopted. The prepared conductive film has high surface resistance, weak bonding force between the film and the substrate, so that the conductive film is prone to falling off the substrate in the process of repeated bending, thus affecting the stability of the OLED device.

### SUMMARY OF THE INVENTION

In view of this, it is necessary to provide an organic electroluminescent device.

Further, the present invention is to provide a method for manufacturing the organic electroluminescent device.

An organic electroluminescent device comprising a substrate, an anode, a light emitting layer and a cathode stacked sequentially, the anode comprises a light transmittance increased layer, a conductive layer and a hole injection auxiliary layer stacked on the substrate sequentially; material of the light transmittance increased layer is inorganic compound of zinc having a light transmittance in the visible range of 400nm to 800nm and a refractive index greater than 2.3; material of the conductive layer is graphene.

Preferably, material of the hole injection auxiliary layer is one compound selected from tungsten trioxide, molybdenum trioxide, vanadium pentoxide and rhenium trioxide.

Preferably, material of light transmittance increased layer is zinc sulfide or zinc selenide.

Preferably, thickness of light transmittance increased layer is in a range of 35nm-80nm, thickness of hole injection auxiliary layer is in a range of 3nm-10nm.

Preferably, there is a buffer layer between the substrate and the anode, the buffer layer is ultraviolet light curing adhesive.

Preferably, thickness of the buffer layer is in a range of 0.5µm-10µm, surface hardness is in a range of 2H-3H.

A method for manufacturing organic electroluminescent device, comprising:
cleaning substrate for later use;
preparing anode on the substrate by the following steps: vapor depositing light transmittance increased layer on the surface of the substrate in a vacuum depositing system at 5×10⁻⁴Pa; taking out the substrate on which the light transmittance increased layer is deposited from the vacuum depositing system; vapor depositing conductive layer on the surface of the light transmittance increased layer by dip-coating process and then transferring into the vacuum depositing system; vapor depositing hole injection auxiliary layer on the surface of the conductive layer to obtain anode;
then vapor depositing light emitting layer and cathode on the anode to obtain the organic electroluminescent device; wherein material of the light transmittance increased layer is inorganic compound of zinc having a light transmittance in the visible range of 400nm to 800nm and a refractive index greater than 2.3, material of the conductive layer is graphene.

Preferably, the dip-coating process comprises the following steps: dipping the substrate on which the light transmittance increased layer is deposited into an aqueous suspension of graphene, pulling the substrate on which the light transmittance increased layer is deposited out of the suspension at a speed of 0.1 cm/s-0.5 cm/s, and drying.

Preferably, a buffer layer is prepared between the substrate and the anode by the following steps: spin coating ultraviolet light curing adhesive on the substrate by a spin coater, curing under ultraviolet lamp to form buffer layer, wherein speed of spin coater is in a range of 1000 r/m-5000 r/m, time of spin coating is in a range of 30 s-120 s.

Preferably, material of the hole injection auxiliary layer is one compound selected from tungsten trioxide, molybdenum trioxide, vanadium pentoxide and rhenium trioxide; material of the light transmittance increased layer is zinc sulfide or zinc selenide.

The organic electroluminescence device manufactured by vacuum vapor deposition and dip-coating process has stacked structure anode. The stacked structure of anode only causes minor damage to substrate. The anode has superior light transmittance and low surface resistance. The bonding force between the anode and the substrate is enhanced by inserting buffer layer. The device has a stable luminous property and a high luminous efficiency.

### BRIEF DESCRIPTION OF THE DRAWINGS

Fig. 1 is a schematic structural view of the organic electroluminescent device according to an embodiment of the present invention;
Fig. 2 is a schematic structural view of the organic electroluminescent device according to another embodiment of the present invention;
Fig. 3 is a flow diagram showing the manufacture of the organic electroluminescent device according to one embodiment of the present invention;
Fig. 4 is a flow diagram showing the manufacture of the organic electroluminescent device according to another embodiment of the present invention;
Fig. 5 shows the relation between luminescence fraction and the number of times the organic electroluminescent devices of the present invention and comparative embodiment are bended. The luminescence fraction is defined as the fraction of L to L₀. L is luminescence of the organic electroluminescent devices being bended to 90 degrees; L₀ is luminescence of organic electroluminescent devices before being bended to 90 degrees.
Fig. 6 shows voltage-current density curves of the organic electroluminescence device of one embodiment of the present invention and comparative embodiment.

### DETAILED DESCRIPTION OF ILLUSTRATED EMBODIMENTS

Further description of the organic electroluminescent device and method for manufacturing the same will be illustrated, which combined with preferred embodiments and the drawings.

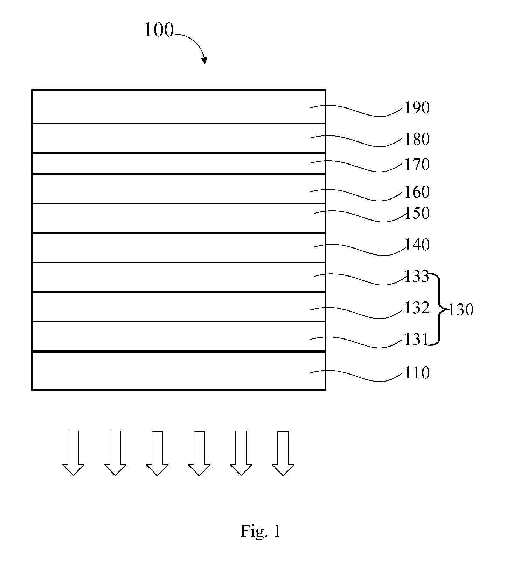

Referring to Fig. 1, in one embodiment of the invention, organic electroluminescent device 100 comprises a substrate 110, an anode 130, a light emitting layer 160 and a cathode 190 stacked sequentially. In order to improve overall performance of organic electroluminescent device 100, a hole injection layer 140, hole transport layer 150, electron transport layer 170 and electron injection layer 180 can be further included as needed.

Substrate 110 can be glass substrate or polymer film, etc. Glass substrate has better light transmittance. To ensure the improvement of light transmittance, polymer thin film is selected from the materials having a visible light transmittance greater than 80% and a thickness in a range of 0.1 mm- 0.5 mm, particularly polyethylene terephthalate (PET), polyether sulfone (PES), polyethylene naphthalate (PEN), cyclic olefin copolymer (COC), polycarbonate (PC), etc.

Anode 130 comprises a light transmittance increased layer 131, a conductive layer 132 and a hole injection auxiliary layer 133. Material of light transmittance increased layer 131 is inorganic compound of zinc having a light transmittance in the visible range of 400nm to 800nm and a refractive index greater than 2.3. Particularly, material of light transmittance increased layer is zinc sulfide or zinc selenide. Preferably, thickness of light transmittance increased layer 131 is in a range of 35nm-80nm.

Material of the conductive layer 132 is graphene.

Material of hole injection auxiliary layer 133 includes one compound selected from tungsten trioxide, molybdenum trioxide, vanadium pentoxide and rhenium trioxide. Thickness is in a range of 3 nm-10 nm.

Anode is prepared on flexible substrate. The multilayer structure anode is designed based on the anti-reflection principle of Heat Mirror, therefore the prepared anode layer has higher visible light transmittance and lower surface resistance. Based on good electrical properties of graphene, in order to further improve hole injection performance of anode, a hole injection auxiliary layer having hole injection ability is used as part of multilayer anode to decrease hole injection barrier. On this basis, a flexible organic electroluminescence device having stable luminous property and high light emitting efficiency is prepared.

Hole injection layer 140 uses a material commonly used in the art, such as 4,4',4'-tris(N-3-methylphenyl-N-phenyl-amino)-triphenylamine (m-MTDATA), thickness is 40 nm.

Hole transport layer 150 uses a material commonly used in the art, such as N,N'-di-[(1-naphthalenyl)-N,N'-diphenyl]- (1,1'-biphenyl)- 4,4'- diamine (NPB), N,N'-bis(3-methylphenyl)-N,N'-diphenyl-benzidine (TPD) and 1,1-bis[4-(N,N-di(p-tolyl)amino)phenyl]cyclohexane (TAPC), thickness is 30 nm.

Light emitting layer 160 uses a material commonly used in the art, such as NPB:Ir(MDQ)₂(acac) (NPB, i.e. N,N'-di-[(1-naphthalenyl)- N,N'-diphenyl]- (1,1'-biphenyl)-4,4'- diamine, is host material, Ir(MDQ)₂(acac), i.e. bis(2-methyldibenzo[f,h]quinoxaline) (acetylacetonate) iridium, is guest material, doping mass percentage of the guest material is 5%);
TCTA:Ir(ppy)₃ (TCTA, i.e. 4,4',4"-tris(carbazol-9-yl)-triphenylamine, is host material, Ir(ppy)₃, i.e. tris(2-phenylpyridine)iridium, is guest material, doping mass percentage of the guest material is 3%);
DCJTB: Alq₃ (Alq₃, i.e. tris(8-hydroxyquinolinato)aluminium, is host material, DCJTB, i.e. 4-(dicyanomethylene)-2-tert-butyl-6-(1,1,7,7-tetramethyljulolidin-4-yl-vinyl)-4h-pyran, is guest material, doping mass percentage of the guest material is 2%);
or DPVBi (4,4'-bis(2,2'-diphenyl vinyl)-1,1'-biphenyl), thickness is 15 nm.

Electron transport layer 170 uses a material commonly used in the art, such as tris(8-hydroxyquinolinato)aluminium (Alq₃), 4,7-diphenyl-1,10-phenanthroline (Bphen) and 1,3,5-tris(1-phenyl-1H-benzimidazol-2-yl)benzene (TPBi), thickness is 40 nm;

Electron injection layer 180 uses a material commonly used in the art, such as lithium fluoride and cesium fluoride, thickness is 1 nm.

Cathode 190 uses a material commonly used in the art, such as aluminum, silver and Mg-Al alloy, thickness is 100 nm.

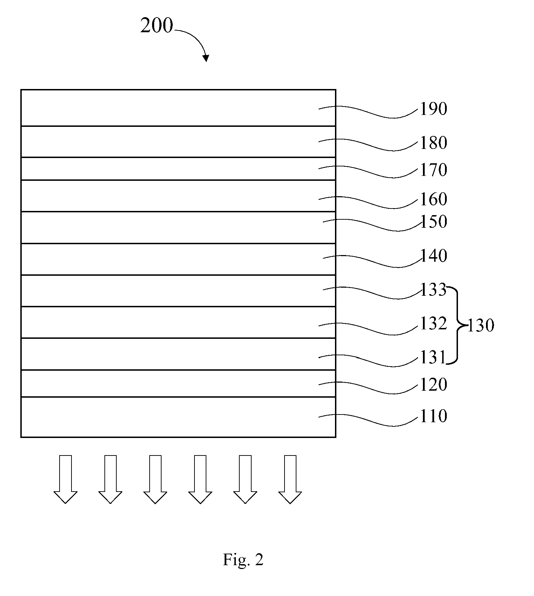

Referring to Fig. 2, in another embodiment of the invention, organic electroluminescent device 200 comprises a substrate 110, a buffer layer 120, an anode 130, a light emitting layer 160 and a cathode 190 stacked sequentially. In order to improve overall performance of organic electroluminescent device 100, a hole injection layer 140, hole transport layer 150, electron transport layer 170 and electron injection layer 180 can be further included as needed.

Substrate 110, anode 130, light emitting layer 160, cathode 190, hole injection layer 140, hole transport layer 150, electron transport layer 170 and electron injection layer 180 are the same as previously mentioned, and not repeated here.

Buffer layer 120 is prepared using ultraviolet light curing adhesive. Thickness of buffer layer 120 can be in a range of 0.5-10µm. Surface hardness of the buffer layer 120 is between 2H-3H (pencil hardness).

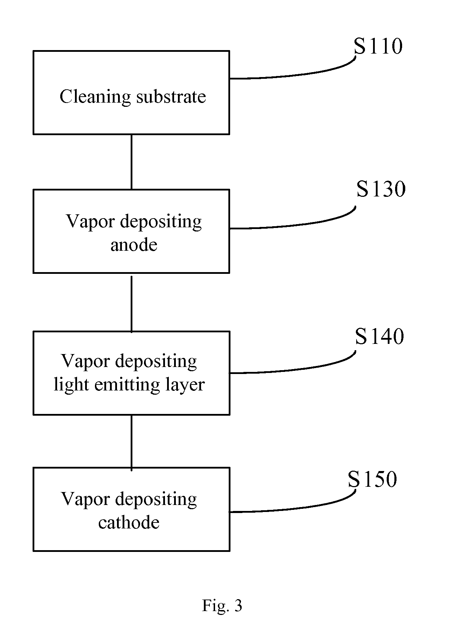

Referring to Fig. 3, a method for manufacturing organic electroluminescent device, comprising:
S110: cleaning substrate;

In one embodiment of the present invention, substrate is ultrasonically cleaned in deionized water containing detergent. After cleaning with deionized water, the substrate is ultrasonically treated successively with isopropanol and acetone, and then dried with nitrogen for later use.

Preferably, material of substrate is polymer film having a visible light transmittance greater than 80% and a thickness of 0.1mm-0.5mm, particularly polyethylene terephthalate (PET), polyether sulfone (PES), polyethylene naphthalate (PEN), cyclic olefin copolymer (COC) and polycarbonate (PC), etc.

S130: preparing anode on the surface of the substrate prepared in S110 by vacuum vapor deposition.

S130 comprises three steps of S131, S132 and S133 to prepare anode.

S131 comprises vapor depositing light transmittance increased layer on the surface of the substrate in a vacuum depositing system at 5×10⁻⁴Pa. Preferably, material of light transmittance increased layer is inorganic compound of zinc having a light transmittance in the visible range of 400nm to 800nm and a refractive index greater than 2.3. Particularly, material of light transmittance increased layer is zinc sulfide or zinc selenide. Thickness is in a range of 35nm-80nm.

S132 comprises taking out the substrate treated by S131 from the vacuum depositing system; vapor depositing conductive layer on the surface of the light transmittance increased layer by dip-coating process. The dip-coating process comprises the step of dispersing material of conductive layer in deionized water to form a 0.01 mg/mL-2.0 mg/mL aqueous suspension.

Preferably, in one embodiment of the present invention, material of conductive layer is single-layer graphene. Concentration of graphene in the aqueous suspension is in a range of 0.01 mg/mL-2.0 mg/mL.

The substrate treated by S131 is dipped into aqueous suspension of graphene and pulled out from the suspension, then dried. This step can be performed for 1-5 times to obtain the desired thickness.

Preferably, thickness of conductive layer is in a range of 10 nm-25 nm.

S133 comprises transferring the substrate treated by S132 into vacuum depositing system at 5×10⁻⁴Pa, and hole injection auxiliary layer is vapor deposited on the surface of conductive layer to obtain anode.

Preferably, material of the hole injection auxiliary layer is one compound selected from tungsten trioxide, molybdenum trioxide, vanadium pentoxide and rhenium trioxide.

Thickness of hole injection auxiliary layer is in a range of 3 nm-10 nm.

S140 comprises vapor depositing light emitting layer on the surface of anode.

Light emitting layer uses a material commonly used in the art, such as NPB:Ir(MDQ)₂(acac) (NPB, i.e. di-[(1-naphthalenyl)- N,N'-diphenyl]- (1,1'-biphenyl)- 4,4'-diamine, is host material, Ir(MDQ)₂(acac), i.e. bis(2-methyldibenzo[f,h]quinoxaline) (acetylacetonate) iridium, is guest material, doping mass percentage of the guest material is 5%);
TCTA:Ir(ppy)₃ (TCTA, i.e. 4,4',4"-tris(carbazol-9-yl)-triphenylamine, is host material, Ir(ppy)₃, i.e. tris(2-phenylpyridine)iridium, is guest material, doping mass percentage of the guest material is 3%);
DCJTB: Alq₃ (Alq₃, i.e. tris(8-hydroxyquinolinato)aluminium, is host material, DCJTB, i.e. 4-(dicyanomethylene)-2-tert-butyl-6-(1,1,7,7-tetramethyljulolidin-4-yl-vinyl)-4h-pyran, is guest material, doping mass percentage of the guest material is 2%);
or DPVBi.
S150 comprises vapor depositing cathode on the surface of light emitting layer.

Cathode uses a material commonly used in the art, such as aluminum, silver and Mg-Al alloy, etc.

In order to improve overall performance of organic electroluminescent device, a hole injection layer and/or hole transport layer can be deposited between anode and light emitting layer, an electron transport layer and/or electron injection layer can be deposited between light emitting layer and cathode.

The vacuum depositing system used in the present invention is commonly used in the art.

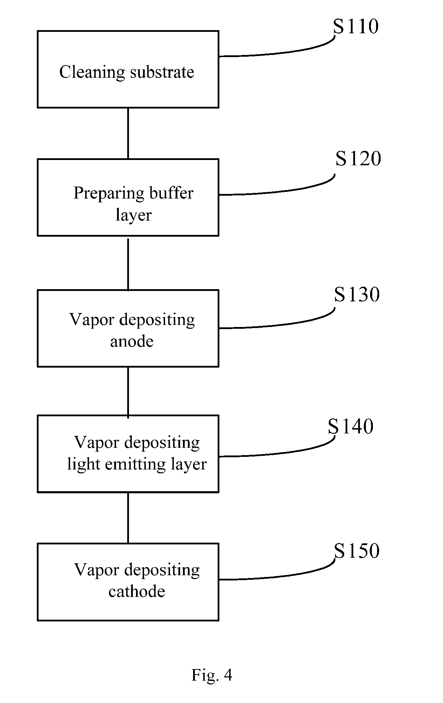

Referring to Fig. 4, another method for manufacturing organic electroluminescent device, comprising:
S110: cleaning substrate; S130: preparing anode on the surface of the substrate by vacuum vapor deposition; S140: vapor depositing light emitting layer on the surface of the anode; and S150: vapor depositing cathode on the surface of light emitting layer. These steps are the same as previously mentioned, and not repeated here. The method further includes S120 which is preparation of buffer layer;
S120 comprises preparing buffer layer by the steps: spin coating ultraviolet light curing adhesive on the substrate treated by S110 by a spin coater; curing under ultraviolet lamp to form buffer layer.

Preferably, speed of spin coater is in a range of 1000 r/m-5000 r/m, time of spin coating is in a range of 30 s-120 s.

Preferably, thickness of buffer layer is in a range of 0.5µm-10µm.

The bonding force between the anode and the substrate is enhanced by inserting buffer layer. The prepared organic electroluminescent device has a good bending endurance performance, a stable luminous property and a high light emitting efficiency.

The present invention will be described below in detail referring to preferred embodiments.

### Example 1

The method for manufacturing organic electroluminescent device is as follows.

Preparation of substrate. Polyethylene naphthalate film having a thickness of 0.1 mm was ultrasonically cleaned in deionized water containing detergent, washed with deionized water, ultrasonically treated successively with isopropanol and acetone, then blow dried with nitrogen.

Preparation of buffer layer. The dried substrate was placed on a spin coater. Speed of the spin coater was set for 1000 r/min. The spin coater started and operated for 120s. An ultraviolet light curing adhesive of 0.5µm thick was coated on the surface of substrate. Then a UV lamp was employed to cure to form a buffer layer. Surface hardness of the buffer layer was 2H.

Preparation of anode. A light transmittance increased layer was deposited on the surface of buffer layer in a vacuum depositing system at 5×10⁻⁴Pa, then taken out from the vacuum depositing system. In this embodiment, zinc sulfide layer having a thickness of 45 nm was used as light transmittance increased layer.

Preparation of conductive layer on the surface of the light transmittance increased layer by dip-coating process. A 0.5 mg/mL aqueous suspension of graphene was used in this embodiment. The substrate was pulled out of the suspension at a speed of 0.2 cm/s, for two times. After drying, the conductive layer was obtained.

Deposition of a hole injection auxiliary layer on the surface of the conductive layer. The substrate obtained previously was transferred into the vacuum depositing system, and a 6 nm thick tungsten trioxide used as hole injection auxiliary layer was deposited on the surface of the conductive layer to form anode.

At last, hole injection layer, hole transport layer, light emitting layer, electron transport layer, electron injection layer and cathode were deposited successively on the surface of the anode.

Material of hole injection layer was 4,4',4'-tris(N-3-methylphenyl-N-phenyl-amino)-triphenylamine (m-MTDATA), thickness of the hole injection layer was 40nm.

Material of hole transport layer was N,N'-di-[(1-naphthalenyl)-N,N'-diphenyl]-(1,1'-biphenyl)- 4,4'- diamine (NPB), thickness of the hole transport layer was 30 nm.

Material of light emitting layer was TCTA:Ir(ppy)₃, where TCTA, i.e. 4,4',4"-tris(carbazol-9-yl)-triphenylamine, was host material, Ir(ppy)₃, i.e. tris(2-phenylpyridine)iridium, was guest material, doping mass percentage of the guest material was 3%, thickness of light emitting layer was 15 nm.

Material of electron transport layer was 1,3,5-tris(1-phenyl-1H-benzimidazol-2-yl)benzene (TPBi), thickness was 40 nm.

Material of electron injection was lithium fluoride (LiF), thickness was 1 nm.

Material of cathode was aluminum, thickness was 100 nm.

The organic electroluminescence device has a structure of PEN/UV adhesive/ZnS/graphene/WO₃/ m-MTDATA/NPB/ TCTA:Ir(ppy)₃/ TPBi /LiF/Al.

Surface hardness test was conducted according to GB-T6739-1996 (Determination of Film Hardness by Pencil Test), using a pencil hardness tester designed in accordance with the national standard. The surface hardness tests of the embodiments below are all conducted in the same manner as in Example 1.

### Example 2

The method for manufacturing organic electroluminescent device is as follows.

Preparation of substrate. Polyethylene terephthalate film having a thickness of 0.175 mm was ultrasonically cleaned in deionized water containing detergent, washed with deionized water, ultrasonically treated successively with isopropanol and acetone, then blow dried with nitrogen;

Preparation of buffer layer. The dried substrate was placed on a spin coater. Speed of the spin coater was set for 5000 r/min. The spin coater started and operated for 30s. An ultraviolet light curing adhesive of 5µm thick was coated on the surface of substrate. Then a UV lamp was employed to cure to form a buffer layer. Surface hardness of the buffer layer was 3H.

Preparation of anode. A light transmittance increased layer was deposited on the surface of buffer layer in a vacuum depositing system at 5×10⁻⁴Pa, then taken out from the vacuum depositing system. In this embodiment, zinc sulfide layer having a thickness of 35 nm was used as light transmittance increased layer.

Preparation of conductive layer on the surface of the light transmittance increased layer by dip-coating process. A 0.01 mg/mL aqueous suspension of graphene was used in this embodiment. The substrate was pulled out of the suspension at a speed of 0.1 cm/s, for one time. After drying, the conductive layer was obtained.

Deposition of a hole injection auxiliary layer on the surface of the conductive layer. The substrate obtained previously was transferred into the vacuum depositing system, and a 3 nm thick molybdenum trioxide used as hole injection auxiliary layer was deposited on the surface of the conductive layer to form anode.

At last, hole injection layer, hole transport layer, light emitting layer, electron transport layer, electron injection layer and cathode were deposited successively on the surface of the anode.

Material of hole injection layer was 4,4',4'-tris(N-3-methylphenyl-N-phenyl-amino)-triphenylamine (m-MTDATA), thickness of the hole injection layer was 40nm.

Material of hole transport layer was N,N'-di-[(1-naphthalenyl)-N,N'-diphenyl]-(1,1'-biphenyl)- 4,4'- diamine (NPB), thickness of the hole transport layer was 30 nm.

Material of light emitting layer was NPB:Ir(MDQ)₂(acac), where NPB, i.e. N,N'-di-[(1-naphthalenyl)- N,N'-diphenyl]- (1,1'-biphenyl)- 4,4'- diamine, was host material, Ir(MDQ)₂(acac), i.e. bis(2-methyldibenzo[f,h]quinoxaline) (acetylacetonate) iridium, was guest material, doping mass percentage of the guest material was 5%; thickness was 15 nm.

Material of electron transport layer was 4,7-diphenyl-1,10-phenanthroline (Bphen), thickness was 40 nm.

Material of electron injection was cesium fluoride (CsF), thickness was 1 nm.

Material of cathode was Mg-Al alloy, thickness was 100 nm.

The organic electroluminescence device has a structure of PET/UV adhesive / ZnS/Ag/MoO₃/m-MTDATA/NPB/ NPB:Ir(MDQ)₂(acac)/Bphen/CsF/ Mg-Ag.

### Example 3

The method for manufacturing organic electroluminescent device is as follows.

Preparation of substrate. Polyether sulfone film having a thickness of 0.2 mm was ultrasonically cleaned in deionized water containing detergent, washed with deionized water, ultrasonically treated successively with isopropanol and acetone, then blow dried with nitrogen;

Preparation of buffer layer. The dried substrate was placed on a spin coater. Speed of the spin coater was set for 4000 r/min. The spin coater started and operated for 70s. An ultraviolet light curing adhesive of 1µm thick was coated on the surface of substrate. Then a UV lamp was employed to cure to form a buffer layer. Surface hardness of the buffer layer was 2H.

Preparation of anode. A light transmittance increased layer was deposited on the surface of buffer layer in a vacuum depositing system at 5×10⁻⁴Pa, then taken out from the vacuum depositing system. In this embodiment, zinc sulfide layer having a thickness of 80 nm was used as light transmittance increased layer.

Preparation of conductive layer on the surface of the light transmittance increased layer by dip-coating process. A 0.1 mg/mL aqueous suspension of graphene was used in this embodiment. The substrate was pulled out of the suspension at a speed of 0.5 cm/s, for five times. After drying, the conductive layer was obtained.

Deposition of a hole injection auxiliary layer on the surface of the conductive layer. The substrate obtained previously was transferred into the vacuum depositing system, and a 5 nm thick rhenium trioxide used as hole injection auxiliary layer was deposited on the surface of the conductive layer to form anode.

At last, hole injection layer, hole transport layer, light emitting layer, electron transport layer, electron injection layer and cathode were deposited successively on the surface of the anode.

Material of hole injection layer was 4,4',4'-tris(N-3-methylphenyl-N-phenyl-amino)-triphenylamine (m-MTDATA), thickness of the hole injection layer was 40nm.

Material of hole transport layer was N,N'-bis(3-methylphenyl)-N,N'-diphenyl-benzidine (TPD), thickness of the hole transport layer was 30 nm.

Material of light emitting layer was DCJTB: Alq₃, where Alq₃, i.e. tris(8-hydroxyquinolinato)aluminium, was host material, DCJTB, i.e. 4-(dicyanomethylene)-2-tert-butyl-6-(1,1,7,7-tetramethyljulolidin-4-yl-vinyl)-4h-pyran, was guest material, doping mass percentage of the guest material was 2%); thickness was 15 nm.

Material of electron transport layer was tris(8-hydroxyquinolinato)aluminium (Alq₃), thickness was 40 nm.

Material of electron injection was lithium fluoride (LiF), thickness was 1 nm.

Material of cathode was silver, thickness was 100 nm.

The organic electroluminescence device has a structure of PES/UV adhesive / ZnS/Ag/ReO₃/m-MTDATA/TPD/ DCJTB:Alq₃/Alq₃/LiF/ Ag.

### Example 4

The method for manufacturing organic electroluminescent device is as follows.

Preparation of substrate. Cyclic olefin copolymer film having a thickness of 0.5 mm was ultrasonically cleaned in deionized water containing detergent, washed with deionized water, ultrasonically treated successively with isopropanol and acetone, then blow dried with nitrogen;

Preparation of buffer layer. The dried substrate was placed on a spin coater. Speed of the spin coater was set for 3000 r/min. The spin coater started and operated for 80 s. An ultraviolet light curing adhesive 10 µm thick was coated on the surface of substrate. Then a UV lamp was employed to cure to form a buffer layer. Surface hardness of the buffer layer was 3H.

Preparation of anode. A light transmittance increased layer was deposited on the surface of buffer layer in a vacuum depositing system at 5×10⁻⁴Pa, then taken out from the vacuum depositing system. In this embodiment, zinc selenide layer having a thickness of 60 nm was used as light transmittance increased layer.

Preparation of conductive layer on the surface of the light transmittance increased layer by dip-coating process. A 0.1 mg/mL aqueous suspension of graphene was used in this embodiment. The substrate was pulled out of the suspension at a speed of 0.2 cm/s, for three times. After drying, the conductive layer was obtained. A hole injection auxiliary layer was then deposited on the surface of the conductive layer. The substrate obtained previously was transferred into the vacuum depositing system, and a 10 nm thick vanadium pentoxide was deposited on the surface of the conductive layer to form anode.

At last, hole injection layer, hole transport layer, light emitting layer, electron transport layer, electron injection layer and cathode were deposited successively on the surface of the anode.

Material of hole injection layer was 4,4',4'-tris(N-3-methylphenyl-N-phenyl-amino)-triphenylamine (m-MTDATA), thickness of the hole injection layer was 40nm.

Material of hole transport layer was 1,1-bis[4-(N,N-di(p-tolyl)amino)phenyl] cyclohexane (TAPC), thickness was 30 nm.

Material of light emitting layer was DPVBi (4,4'-bis(2,2'-diphenyl vinyl)-1,1'-biphenyl), thickness was 15 nm.

Material of electron transport layer was 1,3,5-tris(1-phenyl-1H-benzimidazol-2-yl)benzene (TPBi), thickness was 40 nm.

Material of electron injection was cesium fluoride (CsF), thickness was 1 nm.

Material of cathode was Mg-Al alloy, thickness was 100 nm.

A flexible organic electroluminescence device has a layered structure as COC/UV adhesive/ZnSe/Ag/V₂O₅/m-MTDATA/TAPC/DPVBi/TPBi/CsF/ Mg-Ag.

### Example 5

The method for manufacturing organic electroluminescent device is as follows.

Preparation of substrate. Polycarbonate film having a thickness of 0.4 mm was ultrasonically cleaned in deionized water containing detergent, washed with deionized water, ultrasonically treated successively with isopropanol and acetone, then blow dried with nitrogen;

Preparation of buffer layer. The dried substrate was placed on a spin coater. Speed of the spin coater was set for 2000 r/min. The spin coater started and operated for 50s. An ultraviolet light curing adhesive of 7 µm thick was coated on the surface of substrate. Then a UV lamp was employed to cure to form a buffer layer. Surface hardness of the buffer layer was 2H.

Preparation of anode. A light transmittance increased layer was deposited on the surface of buffer layer in a vacuum depositing system at 5×10⁻⁴Pa, then taken out from the vacuum depositing system. In this embodiment, zinc selenide layer having a thickness of 80 nm was used as light transmittance increased layer.

Preparation of conductive layer on the surface of the light transmittance increased layer by dip-coating process. A 2.0 mg/mL aqueous suspension of graphene was used in this embodiment. The substrate was pulled out of the suspension at a speed of 0.2 cm/s, for one time. After drying, the conductive layer was obtained.

Deposition of a hole injection auxiliary layer on the surface of the conductive layer. The substrate obtained previously was transferred into the vacuum depositing system, and an 8 nm thick molybdenum trioxide used as hole injection auxiliary layer was deposited on the surface of the conductive layer to form anode.

At last, hole injection layer, hole transport layer, light emitting layer, electron transport layer, electron injection layer and cathode were deposited successively on the surface of the anode.

Material of hole injection layer was 4,4',4'-tris(N-3-methylphenyl-N-phenyl-amino)-triphenylamine (m-MTDATA), thickness of the hole injection layer was 40nm.

Material of hole transport layer was N,N'-bis(3-methylphenyl)-N,N'-diphenyl-benzidine (TPD), thickness of the hole transport layer was 30 nm.

Material of light emitting layer was DCJTB: Alq₃, where Alq₃, i.e. tris(8-hydroxyquinolinato)aluminium, was host material, DCJTB, i.e. 4-(dicyanomethylene)-2-tert-butyl-6-(1,1,7,7-tetramethyljulolidin-4-yl-vinyl)-4h-pyran, was guest material, doping mass percentage of the guest material was 2%); thickness was 15 nm.

Material of electron transport layer was 1,3,5-tris(1-phenyl-1H-benzimidazol-2-yl)benzene (TPBi), thickness was 40 nm.

Material of electron injection was lithium fluoride (LiF), thickness was 1 nm;

Material of cathode was silver, thickness was 100 nm.

The organic electroluminescence device has a structure of PC/UV adhesive/ZnSe/graphene/MoO₃/m-MTDATA/TPD/ DCJTB:Alq₃/TPBi/LiF/Ag.

### Comparative Example 1

Polyethylene naphthalate film of 0.1 mm thick was ultrasonically cleaned in deionized water containing detergent, washed with deionized water, ultrasonically treated successively with isopropanol and acetone, then blow dried with nitrogen. By using magnetron sputtering system, an indium tin oxide conductive film of 125 nm thick was prepared on the surface of polyethylene naphthalate film as anode. Then the following layers were deposited successively.

Material of hole injection layer was 4,4',4'-tris(N-3-methylphenyl-N-phenyl-amino)-triphenylamine (m-MTDATA), thickness of the hole injection layer was 40nm.

Material of hole transport layer was N,N'-di-[(1-naphthalenyl)-N,N'-diphenyl]-(1,1'-biphenyl)- 4,4'- diamine (NPB), thickness of the hole transport layer was 30 nm.

Material of light emitting layer was TCTA:Ir(ppy)₃, where TCTA, i.e. 4,4',4"-tris(carbazol-9-yl)-triphenylamine, was host material, Ir(ppy)₃, i.e. tris(2-phenylpyridine)iridium, was guest material, doping mass percentage of the guest material was 3%, thickness of light emitting layer was 15 nm.

Material of electron transport layer was 1,3,5-tris(1-phenyl-1H-benzimidazol-2-yl)benzene (TPBi), thickness was 40 nm.

Material of electron injection was lithium fluoride (LiF), thickness was 1 nm.

Material of cathode was aluminum, thickness was 100 nm.

The organic electroluminescence device has a structure of PEN/ ITO/ m-MTDATA/NPB/ TCTA:Ir(ppy)₃/ TPBi /LiF/Al. This device has no buffer layer, and the anode is indium tin oxide conductive film, other functional layers are the same as Example 1.

Referring to Table 1, table 1 shows the transmittance and conductivity test results of organic electroluminescence devices prepared in Example 1-5 and Comparative Example. Light transmittance test was conducted on an ultraviolet and visible spectrophotometer (model: Perkin Elmer lambda 25), conductivity was determined by a resistivity meter with four point probe (model: CN61M230827, made by Midwest company). Compared to the organic electroluminescence device using ITO as anode prepared in Comparative Example 1, embodiments of the present invention have transmittance very close to 80.2%. Thus it can be seen that the anode of the embodiments of the present invention has relatively good transmittance. However, the square resistance of the organic electroluminescence device of the embodiment of the present invention is much lower. It indicates that the anode of the embodiment of the present invention has relatively good conductivity, then the anode having relatively good conductivity can improve carriers injection and transfer rate, thereby increasing luminous efficiency.

**Table 1**

| | Transmittance | Square resistance Ω/□ |
|---|---|---|
| Example 1 | 80.5% | 6 |
| Example 2 | 80.1% | 8 |
| Example 3 | 77.6% | 5 |
| Example 4 | 73.6% | 8 |
| Example 5 | 72.8% | 5 |
| Comparative Example 1 | 80.2% | 56 |

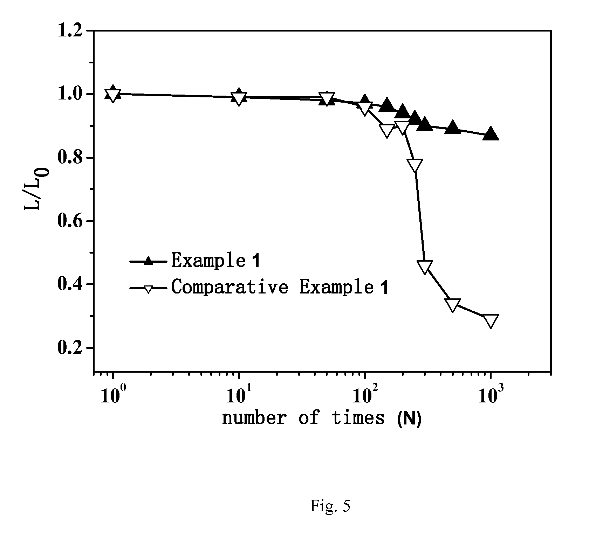

Referring to Fig. 5, Fig. 5 shows the relationship between luminescence fraction and the number of times the organic electroluminescence devices of the present invention and comparative embodiment are bended. The luminescence fraction is defined as the fraction of luminescence of the organic electroluminescent devices being bended to 90 degrees and before being bended to 90 degrees. It can be seen that the electroluminescence device prepared in the Example 1 has very good bonding force between anode and substrate. Luminous performance is stable even the device is repeatedly bended to 90 degrees. However, the anode of comparative embodiment is prone to falling off the substrate after repeatedly bended, thus decreasing luminous efficiency. For example, after being bended for 1000 times, the embodiment of the present invention maintains the initial luminescence of 87%, whereas the comparative embodiment maintains only 29%.

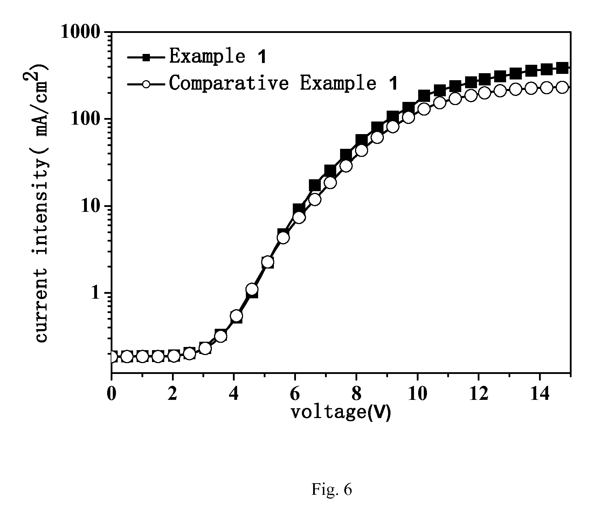

Referring to Fig. 6, Fig. 6 shows voltage-current density curves of the organic electroluminescence device of one embodiment of the present invention and comparative embodiment. It can be seen from the figure that, the organic electroluminescence device prepared in Example 1 has better electron injection than comparative embodiment at the same driving voltage. The organic electroluminescence device prepared in Example 1 has higher current density, it indicates that the anode provided in the present invention has better hole injection performance, thus obtaining better electroluminescence.

While the present invention has been described with reference to particular embodiments, it will be understood that the embodiments are illustrative and that the invention scope is not so limited. Alternative embodiments of the present invention will become apparent to those having ordinary skill in the art to which the present invention pertains. Such alternate embodiments are considered to be encompassed within the spirit and scope of the present invention. Accordingly, the scope of the present invention is described by the appended claims and is supported by the foregoing description.

## Claims

1. An organic electroluminescent device comprising a substrate, an anode, a light emitting layer and a cathode stacked sequentially, wherein the anode comprises a light transmittance increased layer, a conductive layer and a hole injection auxiliary layer stacked on the substrate sequentially; material of the light transmittance increased layer is inorganic compound of zinc having a light transmittance in the visible range of 400nm to 800nm and a refractive index greater than 2.3; material of the conductive layer is graphene.

2. The organic electroluminescent device according to claim 1, wherein material of the hole injection auxiliary layer is one compound selected from tungsten trioxide, molybdenum trioxide, vanadium pentoxide and rhenium trioxide.

3. The organic electroluminescent device according to claim 1, wherein material of the light transmittance increased layer is zinc sulfide or zinc selenide.

4. The organic electroluminescent device according to claim 1, wherein thickness of the light transmittance increased layer is in a range of 35nm-80nm, thickness of the hole injection auxiliary layer is in a range of 3nm-10nm.

5. The organic electroluminescent device according to any one of the claims from 1 to 4, further comprising a buffer layer between the substrate and the anode, material of the buffer layer is ultraviolet light curing adhesive.

6. The organic electroluminescent device according to claim 5, wherein thickness of the buffer layer is in a range of 0.5µm-10µm, surface hardness is in a range of 2H-3H.

7. A method for manufacturing organic electroluminescent device, comprising:
cleaning substrate for later use;
preparing anode on the substrate by the following steps: vapor depositing light transmittance increased layer on the surface of the substrate in a vacuum depositing system at 5×10⁻⁴Pa; taking out the substrate on which the light transmittance increased layer is deposited from the vacuum depositing system; vapor depositing conductive layer on the surface of the light transmittance increased layer by dip-coating process and then transferring into the vacuum depositing system; vapor depositing hole injection auxiliary layer on the surface of the conductive layer to obtain anode;
then vapor depositing light emitting layer and cathode on the anode to obtain the organic electroluminescent device;
wherein material of the light transmittance increased layer is inorganic compound of zinc having a light transmittance in the visible range of 400nm to 800nm and a refractive index greater than 2.3, material of the conductive layer is graphene.

8. The method for manufacturing organic electroluminescent device according to claim 7, wherein the dip-coating process comprises: dipping the substrate on which the light transmittance increased layer is deposited into an aqueous suspension of graphene, pulling the substrate on which the light transmittance increased layer is deposited out of the suspension at a speed of 0.1 cm/s-0.5 cm/s, and drying.

9. The method for manufacturing organic electroluminescent device according to claim 7, further comprising preparation of a buffer layer between the substrate and the anode, which comprises the steps of:
spin coating ultraviolet light curing adhesive on the substrate by a spin coater;
curing under ultraviolet lamp to form buffer layer; wherein speed of spin coater is in a range of 1000 r/m-5000 r/m, time of spin coating is in a range of 30 s-120 s.

10. The method for manufacturing organic electroluminescent device according to claim 7, wherein material of the hole injection auxiliary layer is one compound selected from tungsten trioxide, molybdenum trioxide, vanadium pentoxide and rhenium trioxide, material of the light transmittance increased layer is zinc sulfide or zinc selenide.
